# EUROPEAN PATENT APPLICATION

(11) **EP 2 472 596 A1**
(43) Date of publication of application: **04.07.2012**
(21) Application number: 09849497.4
(22) Date of filing: 17.09.2009
(51) Int. Cl.: H01L 31/042

(54) **SOLAR CELL MODULE**

(71) Applicant: Mitsubishi Electric Corporation, Tokyo 100-8310 (JP)
(72) Inventor: SUGANUMA, Yoshiyuki, Tokyo 100-8310 (JP); SUZUKI, Issei, Tokyo 100-8310 (JP)
(74) Representative: Pfenning, Meinig & Partner GbR
(86) International application number: PCT/JP2009/066288
(87) International publication number: WO 2011/033638

(57) **Abstract**

A photovoltaic module includes a cable retaining section (37) provided on the rear surface of a planar photovoltaic panel that converts sunlight into electric power and configured to retain first and second output cables (21, 22) drawn around on the rear surface of the photovoltaic panel. The cable retaining section (37) includes an intermediate plate (33) erected on the rear surface of the photovoltaic panel, a first spring plate (31) having elasticity, erected on the rear surface of the photovoltaic panel to be opposed to the intermediate plate (33), and configured to hold and clamp the first output cable (21) between the first spring plate (31) and the intermediate plate (33), and a second spring plate (32) having elasticity, erected on the rear surface of the photovoltaic panel to be opposed to the intermediate panel (33) on the opposite side of the first spring plate (31), and configured to hold and clamp the second output cable (22) between the second spring plate (32) and the intermediate plate (33).

## Description

### Field

The present invention relates to a photovoltaic module set in buildings such as a house and an office building.

### Background

A photovoltaic cell converts sunlight into electric power. In the past, as the photovoltaic module, a photovoltaic module is frequently used that has structure in which a transparent substrate (glass) is arranged on a light receiving surface side, a plurality of photovoltaic cells connected in series are arranged side by side on the rear surface side of the transparent substrate, the photovoltaic cells are sealed with sealing resin to configure a photovoltaic panel, a frame is attached to the peripheral edge of the photovoltaic panel, and a terminal box is provided on the rear surface of the photovoltaic panel.

The photovoltaic cells are connected in series by an internal lead wire. On the other hand, to extract electric power generated by the photovoltaic cells to the outside, plus and minus two output cables are connected to the photovoltaic panel. In general, a terminal box is attached to the rear surface of the photovoltaic panel. In the terminal box, the internal lead wire extending out from the photovoltaic panel and the output cables are connected.

In other words, the two output cables extend out from the terminal box provided on the rear surface of the photovoltaic panel. The output cables extend to another photovoltaic module, a control device, or the like. If the output cables hang down from the terminal box when extending out from the terminal box, the output cables come into contact with other equipment to be damaged and hinder work.

To cope with this problem, in the past, it is proposed to provide a cable retaining section (a cable clip), which retains the output cables in an engaged state, in a predetermined position of the rear surface of the photovoltaic panel. According to this proposal, the cable retaining section is caused to retain the output cables extending from the terminal box. Consequently, the output cables can be satisfactorily drawn around on the rear surface of the photovoltaic panel without hanging down (e.g., Patent Literature 1).

### Citation List

### Patent Literature

Patent Literature 1: Japanese Patent Application Laid-open No. 2000-031517

### Summary

### Technical Problem

However, in the photovoltaic module having the structure proposed in Patent Literature 1, structure for holding a cable from both sides with spring plates is adopted. In other words, because two spring plates are necessary for one cable and the structure is complicated, improvement is desired. On the other hand, in the photovoltaic module having such structure, as permanent objects, there are a reduction in size, a reduction in cost, improvement of workability, and the like.

The present invention has been devised in view of the above and it is an object of the present invention to provide a photovoltaic module that can be configured in simple structure and therefor can realize a reduction in size and a reduction cost and improve workability.

### Solution to Problem

In order to solve the aforementioned problems and attain the aforementioned object, the photovoltaic module according to one aspect of the present invention is constructed in such manner as to have a planar photovoltaic panel configured to convert sunlight into electric power; first and second output cables electrically connected to the photovoltaic panel and configured to extract generated electric power; and a cable retaining section provided on a rear surface of the photovoltaic panel and configured to retain the first and second output cables drawn around on the rear surface of the photovoltaic panel, wherein the cable retaining section includes: an intermediate plate erected on the rear surface of the photovoltaic panel; a first spring plate having elasticity, erected on the rear surface of the photovoltaic panel to be opposed to the intermediate plate, and configured to hold and clamp the first output cable between the first spring plate and the intermediate plate; and a second spring plate having elasticity, erected on the rear surface of the photovoltaic panel to be opposed to the intermediate plate on an opposite side of the first spring plate, and configured to hold and clamp the second output cable between the second spring plate and the intermediate plate.

In order to solve the aforementioned problems and attain the aforementioned object, the photovoltaic module according to other aspect of the present invention is constructed in such manner as to have a planar photovoltaic panel configured to convert sunlight into electric power; first and second output cables electrically connected to the photovoltaic panel and configured to extract generated electric power; a rim-like frame configured to surround the photovoltaic panel; a reinforcing frame laid over between the rim-like frames on a rear surface side of the photovoltaic panel; and a cushioning material arranged between the photovoltaic panel and the reinforcing frame and configured to suppress a bend of the photovoltaic panel, wherein the cushioning material includes a cushioning material body and a cable retaining section configured to retain the output cables, the cable retaining section includes: a base extending from the cushioning material body; an intermediate plate erected on the base; a first spring plate having elasticity, erected on the base to be opposed to the intermediate plate, and configured to hold and clamp the first output cable between the first spring plate and the intermediate plate; and a second spring plate having elasticity, erected on the base to be opposed to the intermediate plate on an opposite side of the first spring plate, and configured to hold and clamp the second output cable between the second spring plate and the intermediate plate.

### Advantageous Effects of Invention

According to the present invention, because the cable remaining section includes the one intermediate plate and the two spring plates and can be configured in simple structure, it is possible to realize a reduction in size and a reduction in cost. Because the two output cables can be mounted at a time, workability is improved. Further, because the cable retaining section is formed integrally with the cushioning material, it is possible to form the cable retaining section without increasing the number of components and suppress an increase in cost.

### Brief Description of Drawings

FIG. 1 is a perspective view of a state of an initial step of assembly in a first embodiment of a photovoltaic module according to the present invention.
FIG. 2 is a perspective view of a state in which a reinforcing frame is attached to an intermediate assembly, which is obtained by attaching a rim-like frame to the outer edge of a photovoltaic panel, from the rear surface of the intermediate assembly.
FIG. 3 is a perspective view of a state in which the attachment of the reinforcing frame to the intermediate assembly is completed.
FIG. 4 is a sectional view of a state in which the photovoltaic panel does not come into contact with the reinforcing frame even when the photovoltaic panel receives positive pressure and bends.
FIG. 5 is a perspective view of a cushioning material.
FIG. 6 is a perspective view of the cushioning material viewed from the rear surface.
FIG. 7 is a top view of the cushioning material.
FIG. 8 is an arrow sectional view along an A-A line of FIG. 7.
FIG. 9 is an enlarged view of a B section of FIG. 8 and is a diagram of a state in which cables are inserted into a cable retaining section.
FIG. 10 is an enlarged view of the B section of FIG. 8 and is a diagram of a state in which the cables are retained by the cable retaining section.

### Description of Embodiments

Embodiments of a photovoltaic module according to the present invention are explained in detail below based on the drawings. The present invention is not limited by the embodiments.

### First Embodiment.

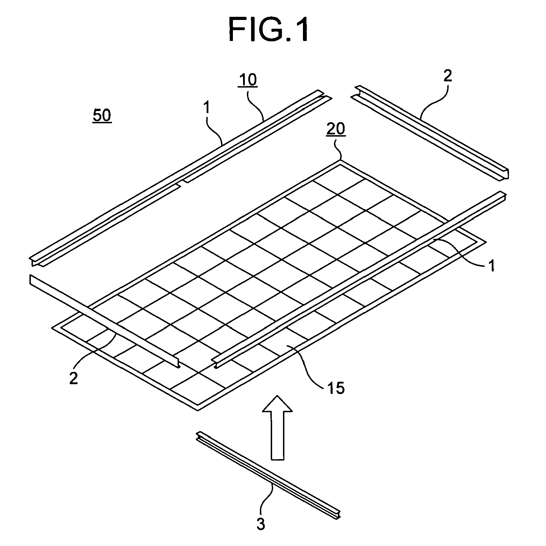

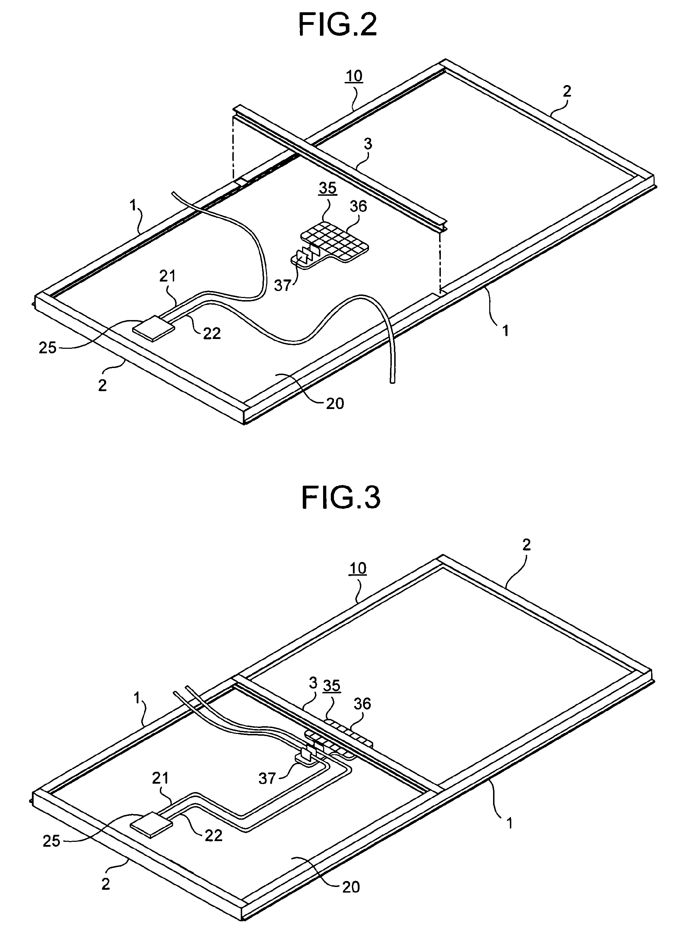

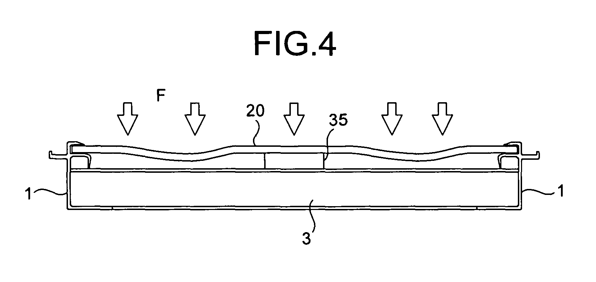

FIG. 1 is a perspective view of a state of an initial step of assembly in a first embodiment of the photovoltaic module according to the present invention. FIG. 2 is a perspective view of a state in which a reinforcing frame is attached to an intermediate assembly, which is obtained by attaching a rim-like frame to the outer edge of a photovoltaic panel, from the rear surface of the intermediate assembly. FIG. 3 is a perspective view of a state in which the attachment of the reinforcing frame to the intermediate assembly is completed. FIG. 4 is a sectional view of a state in which the photovoltaic panel does not come into contact with the reinforcing frame even when the photovoltaic panel receives positive pressure and bends. A state of the photovoltaic panel viewed from the front side is shown in FIG. 1. On the other hand, a state of the photovoltaic panel viewed from the rear side is shown in FIGS. 2 and 3.

A photovoltaic module 50 includes a photovoltaic panel 20 formed in a substantially rectangular planar shape and configured to convert sunlight into electric power, a first output cable 21 and a second output cable 22 configured to extract generated electric power, a terminal box 25 provided on the rear surface of the photovoltaic panel 20 and used to electrically connect an internal lead wire incorporated in the photovoltaic panel 20 and, the first and second output cables 21 and 22, a rim-like frame 10 formed in a rectangular rim shape that surrounds the outer edge of the photovoltaic panel 20 over the entire periphery, a reinforcing frame 3 attached to the rim-like frame 10, and a cushioning material 35 arranged between the photovoltaic panel 20 and the reinforcing frame 3, and configured to suppress a bend of the photovoltaic panel 20. The cushioning material 35 is firmly fixed to a position of the rear surface of the photovoltaic panel 20 where the reinforcing frame 3 is present.

As shown in FIG. 1, the photovoltaic panel 20 is configured by arranging a plurality of photovoltaic cells 15 lengthwise and crosswise and formed in a substantially rectangular planar shape. The photovoltaic cells 15 are connected in series by a not-shown internal lead wire. The rim-like frame 10 includes an opposed pair of long side frames 1, 1 and a pair of short side frames 2, 2 coupled between both ends of the long side frames 1, 1. The pair of long side frames 1, 1 and the pair of short side frames 2, 2 are coupled to each other and formed as the rim-like frame 10 having the rectangular rim shape.

As shown in FIG. 2, the cushioning material 35 is made of a hard material such as aluminum or hard resin, formed in a substantially planar shape, and firmly fixed to the rear surface of the photovoltaic panel 20. As a characteristic of this embodiment, the cushioning material 35 includes a cable retaining section 37 configured to retain the first output cable 21 and the second output cable 22. The cable retaining section 37 includes three plates configured to retain the first output cable 21 and the second output cable 22 in an engaged state (in FIGS. 2 and 3, the three plates are simplified). Details of the cable retaining section 37 are explained later. The cable retaining section 37 in this embodiment is provided in the cushioning material 35. However, a place where the cable retaining section 37 is provided is not limited to the cushioning material 35 and, for example, can be directly formed on the rear surface of the photovoltaic panel 20.

Cutouts for fitting in the reinforcing frame 3 are respectively provided in the centers of the rear surfaces of the long side frames 1, 1. The reinforcing frame 3 is assembled to the long side frames 1, 1 with both ends of the reinforcing frame 3 dropped into the fit-in cutouts from the rear surface side. The reinforcing frame 3 is laid over the opposed long side frames 1, 1 of the rim-like frame 10 and attached to the rim-like frame 10 in a position where the cushioning material 35 is held between the reinforcing frame 3 and the photovoltaic panel 20.

As shown in FIG. 4, the cushioning material 35 has predetermined height. Therefore, a predetermined gap is formed between the photovoltaic panel 20 and the reinforcing frame 3. Therefore, even when the photovoltaic panel 20 receives positive pressure acting as indicated by arrows F in the figure and bends, the rear surface of the photovoltaic panel 20 does not come into contact with the reinforcing frame 3. At this point, if the cushioning material 35 is low, the photovoltaic panel 20 comes into contact with the reinforcing frame 3.

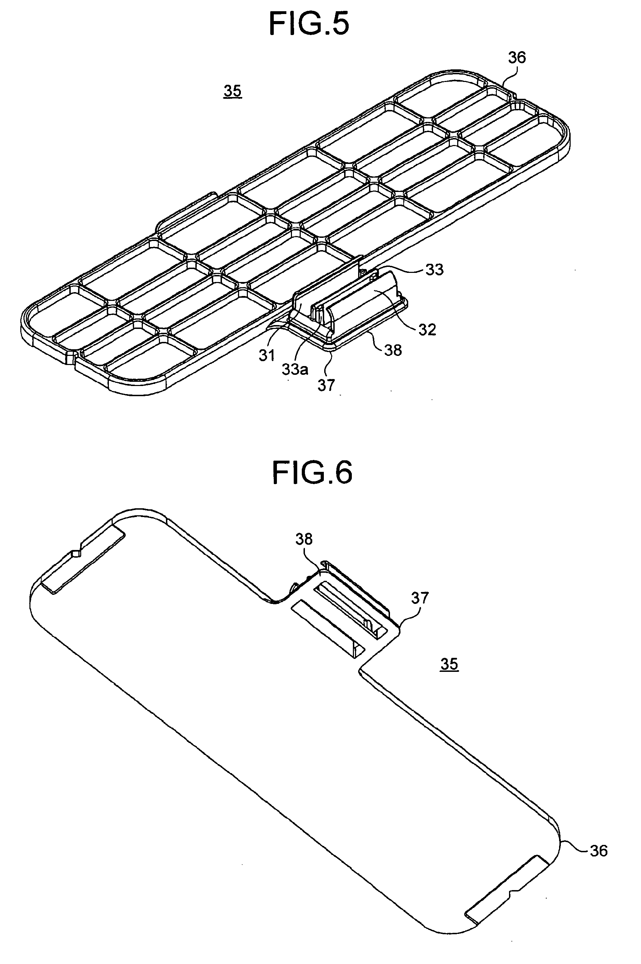

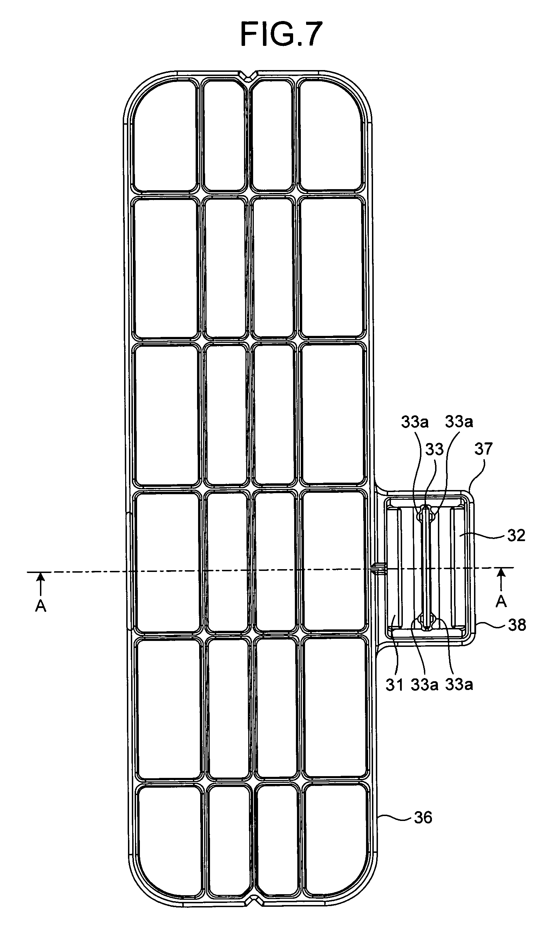

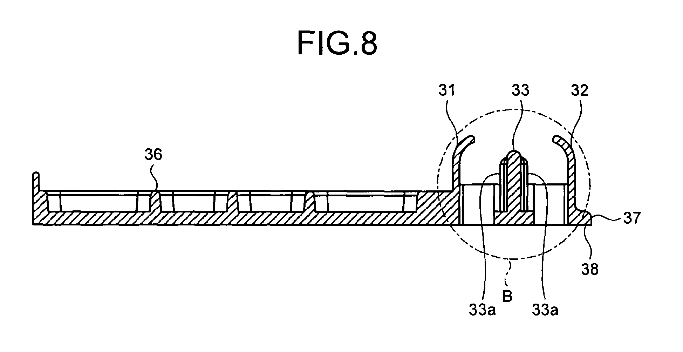

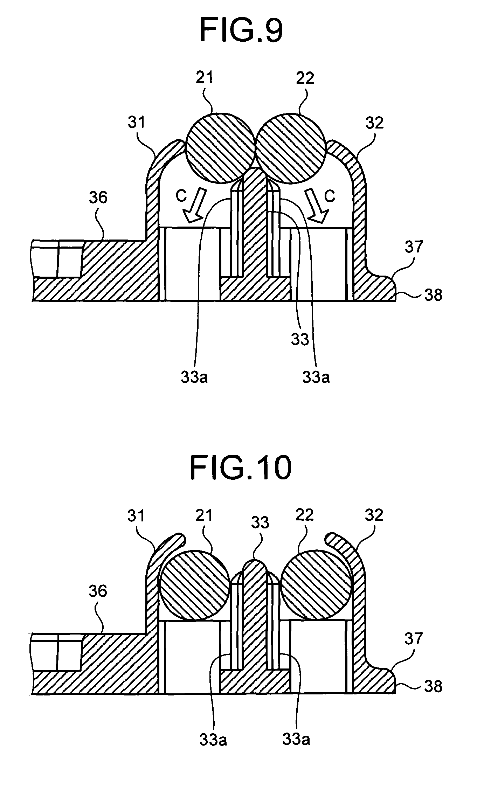

FIG. 5 is a perspective view of the cushioning material 35. FIG. 6 is a perspective view of the cushioning material 35 viewed from the rear surface. FIG. 7 is a top view of the cushioning material 35. FIG. 8 is an arrow sectional view along an A-A line of FIG. 7. FIG. 9 is an enlarged view of a B section of FIG. 8 and is a diagram of a state in which the cables are inserted into the cable retaining section. FIG. 10 is a diagram of a state in which the cables are retained by the cable retaining section. The cushioning material 35 includes a cushioning material body 36 formed in a substantially planer shape and configured to perform an original function of a cushioning material and the cable retaining section 37 configured to retain the first output cable 21 and the second output cable 22.

The cable retaining section 37 includes a base 38 having a substantially planar shape extending on the same plane from a side end of the cushioning material body 36, an intermediate plate 33 erected in the vertical direction on the upper surface of the base 38, a first spring plate 31 erected on the base 38 to be opposed to the intermediate plate 33, and a second spring plate 32 erected on the base 38 to be opposed to the intermediate plate 33 on the opposite side of the first spring plate 31 with the intermediate plate 33 set as the center of symmetry.

Each of the first spring plate 31 and the second spring plate 32 extends higher than the intermediate plate 33 in the erecting direction. Each of the upper ends of the first spring plate 31 and the second spring plate 32 is curved in an arc shape in section to the intermediate plate 33 side. A ridge section of the upper side of the intermediate plate 33 is sharpened in a substantially triangular shape in section to make it easy to divide and select the first output cable 21 and the second output cable 22. The first spring plate 31 and the second spring plate 32 have predetermined elasticity to bend with predetermined pressing force when the first output cable 21 and the second output cable 22 are attached and detached. On the other hand, the intermediate plate 33 has predetermined rigidity.

As shown in FIG. 9, when the two first and second output cables 21 and 22 are lined up and pushed in from above in the figure, the distal end portions of the first spring plate 31 and the second spring plate 32 bend and a space of an inserting opening is widened. The output cables 21 and 22 move as indicated by arrows C and are retained in the cable retaining section 37. In this position where the output cables 21 and 22 are retained, a space between the first spring plate 31 and the intermediate plate 33 and a space between the second spring plate 32 and the intermediate plate 33 is slightly smaller than the diameter of the output cables 21 and 22. Therefore, the first output cable 21 is held and clamped between the first spring plate 31 and the intermediate plate 33. The second output cable 22 is held and clamped between the second spring plate 32 and the intermediate plate 33. The output cables 21 and 22 are stably retained. A space between the distal end of the first spring plate 31 and the distal end of the intermediate plate 33 and a space between the distal end of the second spring plate 32 and the distal end of the intermediate plate 33 are set slightly narrower than a space between positions where the output cables 21 and 22 are retained. Therefore, unless force equal to or larger than predetermined force is applied, the output cables 21 and 22 do not jump out.

Projections 33a extending in an inserting direction of the output cables 21 and 22 are formed in positions a predetermined distance apart from each other in an extending direction of the output cables 21 and 22 (both ends of the intermediate plate 33 in the length direction of the output cables 21 and 22) on surfaces of the intermediate plate 33 respectively opposed to the first spring plate 31 and the second spring plate 32. The projections 33a clamp the first output cable 21 and the second output cable 22 partially in narrower width between the projections 33a and the first spring plate 31 and the second spring plate 32. Consequently, the first output cable 21 and the second output cable 22 are regulated to move in the length direction and more stably retained.

As explained above, in the photovoltaic module according to this embodiment, the cable retaining section 37 includes the intermediate plate 33 erected on the rear surface of the photovoltaic panel 20, the first spring plate 31 erected to be opposed to the intermediate plate 33 and configured to hold and clamp the first output cable 21 between the first spring plate 31 and the intermediate plate 33, and the second spring plate 32 erected to be opposed to the intermediate plate 33 on the opposite side of the first spring plate 31 and configured to hold and clamp the second output cable 22 between the second spring plate 32 and the intermediate plate 33. In other words, the first spring plate 31 and the second spring plate 32 share the intermediate plate 33 when the first spring plate 31 and the second spring plate 32 respectively retain the first output cable 21 and the second output cable 22.

In the photovoltaic module according to this embodiment, because the photovoltaic module has the configuration explained above, the first output cable 21 and the second output cable 22 can be simultaneously and easily mounted on the cable retaining section 37. Consequently, because workability is improved, it is possible to realize a reduction in cost. Because four spring plates required in the past are reduced to two spring plates and the structure is simplified, it is possible to realize a further reduction in cost and realize a reduction in size according to a reduction in the number of plates.

### Industrial Applicability

As explained above, the photovoltaic module according to the present invention is useful for a photovoltaic module in which a plurality of output cables are connected to the photovoltaic panel from the rear surface of the photovoltaic panel.

### Reference Signs List

- 1: LONG SIDE FRAMES

- 2: SHORT SIDE FRAMES
- 3: REINFORCING FRAME
- 10: RECTANGULAR RIM-LIKE FRAME
- 15: PHOTOVOLTAIC CELLS
- 20: PHOTOVOLTAIC PANEL
- 21: FIRST CABLE
- 22: SECOND CABLE
- 25: TERMINAL BOX
- 31: FIRST SPRING PLATE
- 32: SECOND SPRING PLATE
- 33: INTERMEDIATE PLATE
- 35: CUSHIONING MATERIAL
- 36: CUSHIONING MATERIAL BODY
- 37: CABLE RETAINING SECTION
- 38: BASE
- 50: PHOTOVOLTAIC MODULE

## Claims

1. A photovoltaic module comprising:
a planar photovoltaic panel configured to convert sunlight into electric power;
first and second output cables electrically connected to the photovoltaic panel and configured to extract generated electric power; and
a cable retaining section provided on a rear surface of the photovoltaic panel and configured to retain the first and second output cables drawn around on the rear surface of the photovoltaic panel, wherein
the cable retaining section includes:
an intermediate plate erected on the rear surface of the photovoltaic panel;
a first spring plate having elasticity, erected on the rear surface of the photovoltaic panel to be opposed to the intermediate plate, and configured to hold and clamp the first output cable between the first spring plate and the intermediate plate; and
a second spring plate having elasticity, erected on the rear surface of the photovoltaic panel to be opposed to the intermediate plate on an opposite side of the first spring plate, and configured to hold and clamp the second output cable between the second spring plate and the intermediate plate.

2. The photovoltaic module according to claim 1, further comprising:
a rim-like frame configured to surround the photovoltaic panel;
a reinforcing frame laid over between the rim-like frames on the rear surface side of the photovoltaic panel; and
a cushioning material arranged between the photovoltaic panel and the reinforcing frame and configured to suppress a bend of the photovoltaic panel, wherein
the intermediate plate, the first spring plate, and the second spring plate are formed integrally with the cushioning material.

3. A photovoltaic module comprising:
a planar photovoltaic panel configured to convert sunlight into electric power;
first and second output cables electrically connected to the photovoltaic panel and configured to extract generated electric power;
a rim-like frame configured to surround the photovoltaic panel;
a reinforcing frame laid over between the rim-like frames on a rear surface side of the photovoltaic panel; and
a cushioning material arranged between the photovoltaic panel and the reinforcing frame and configured to suppress a bend of the photovoltaic panel, wherein
the cushioning material includes a cushioning material body and a cable retaining section configured to retain the output cables,
the cable retaining section includes:
a base extending from the cushioning material body;
an intermediate plate erected on the base;
a first spring plate having elasticity, erected on the base to be opposed to the intermediate plate, and configured to hold and clamp the first output cable between the first spring plate and the intermediate plate; and
a second spring plate having elasticity, erected on the base to be opposed to the intermediate plate on an opposite side of the first spring plate, and configured to hold and clamp the second output cable between the second spring plate and the intermediate plate.

4. The photovoltaic module according to claim 1, wherein each of the first spring plate and the second spring plate extends higher than the intermediate plate in an erecting direction and each of upper ends of the first spring plate and the second spring plate curves to the intermediate plate side.

5. The photovoltaic module according to claim 1, wherein projections configured to clamp the first and second output cables in narrower width are provided in positions a predetermined distance apart from each other in a length direction of the first and second output cables on surfaces of the intermediate plate respectively opposed to the first spring plate and the second spring plate.
